# EUROPEAN PATENT SPECIFICATION

(11) **EP 1 898 449 B1**
(45) Date of publication and mention of the grant of the patent: **08.06.2011**
(21) Application number: 06120181.0
(22) Date of filing: 06.09.2006
(51) Int. Cl.: H01L 21/02, H01L 21/20

(54) **Compound semiconductor devices and methods of manufacturing the same**
Verbindungshalbleiterbauelement und Verfahren zu seiner Herstellung
Dispositif à semiconducteur composé et procédés de sa fabrication

(43) Date of publication of application: 12.03.2008
(73) Proprietor: Siltron Inc., Gumi-Shi Gyeongsangbuk-Do (KR); LG Display Co., Ltd., Youngdungpo-Gu Seoul (KR)
(72) Inventor: Yi, Gyu-Chul, Gyeongsangbuk-do, 790-751 (KR); An, Sung-Jin, Gyeongsangbuk-Do (KR); Kim, Yong-Jin, Gyeongsangbuk-Do (KR); Lee, Dong-Kun, Gyeongsangbuk-Do (KR)
(74) Representative: Behnisch, Werner

(56) References cited:
- US-A- 5 427 630
- US-A1- 2002 013 042
- US-A1- 2004 077 156
- US-B1- 6 344 403
- YATES H M ET AL: "Atmospheric pressure MOCVD growth of crystalline InP in opals" JOURNAL OF CRYSTAL GROWTH, ELSEVIER, AMSTERDAM, NL, vol. 193, no. 1-2, 15 September 1998 (1998-09-15), pages 9-15, XP004142209 ISSN: 0022-0248
- YATES H M ET AL: "GROWTH OF TIN OXIDE IN OPAL" CHEMICAL VAPOR DEPOSITION, WILEY-VCH VERLAG, WEINHEIM, DE, vol. 6, no. 6, November 2000 (2000-11), pages 283-285, XP000975933 ISSN: 0948-1907
- CHUNHUA T ET AL: "Preparation of InP-SiO2 3D photonic crystals" PHYSICA B. CONDENSED MATTER, AMSTERDAM, NL, vol. 363, no. 1-4, 15 June 2005 (2005-06-15), pages 1-6, XP004900122 ISSN: 0921-4526
- I. M. POVEY, ET AL: "Photonic crystal thin films of GaAs prepared by atomic layer deposition" APPLIED PHYSICS LETTERS, vol. 89, no. 104103, 6 September 2006 (2006-09-06), pages 1-3, XP009079686

## Description

### BACKGROUND

### Technical Field

Compound semiconductor devices are disclosed which have a compound semiconductor thin film grown on a substrate on which spherical balls are coated. Methods of manufacturing the same are also disclosed.

### Description of the Related Art

Gallium nitride (GaN) is known as a material that is useful for blue light-emitting devices or high-temperature electronic devices. However, it is not easy to fabricate a GaN single-crystalline substrate. Because GaN solid has a very high melting point (72000°C) and/or can decompose into Ga and N₂ before it melts, GaN crystals cannot be made using a typical Czochralski technique for growing crystals from a solution. Although it may be possible to form a GaN solution by applying an ultra-high voltage to the GaN solid, this method becomes problematic in terms of mass production.

Because of the increased demand for light emitting devices that emit blue wavelength light, nitride (or GaN-based) thin films have become necessary. Further, various methods are being employed to improve the luminous efficiency of the light emitting devices. In recent years, an epitaxial lateral overgrowth (ELO) method has been used to manufacture a high-quality nitride semiconductor thin film that determines internal quantum efficiency. The ELO method is applied to manufacture of high-speed devices, such as blue laser diodes using homoepitaxy, an ultraviolet (UV) laser diode, a high-temperature/high-output device, a high electron mobility transistor (HEMT), or a heterojunction bipolar transistor (HBT).

In the ELO method, stress resulting from differences in lattice constant and thermal expansion coefficient between the substrate and the GaN crystal is reduced using a "stripe-shaped" or striped SiO₂ mask. Specifically, the ELO method includes growing a GaN thin film on a substrate. The substrate and the GaN thin film are then taken out of a reactor and loaded into a deposition apparatus. A SiO₂ thin film is formed on the GaN thin film. After being unloaded from the deposition apparatus, a SiO₂ mask pattern is formed with photolithography and etching processes. Subsequently, the resultant structure is loaded again into the reactor, and then a GaN thin film is formed thereon. However, such an ELO method involves complicated processes as described above, includes numerous steps including loading and unloading and takes much time.

An example of the ELO method is disclosed in Japanese Patent Laid-Open Publication No. 2000-22212 entitled "GaN Single Crystalline Substrate and Method of Manufacturing the Same." Also, Korean Patent Laid-Open Publication No. 10-2004-0101179 entitled "Substrate for Growing GaN, Method of Manufacturing the Same, and Method of Manufacturing GaN substrate" introduces a method of growing low-potential GaN crystals using both an ELO method and a defect mask method. In addition, Korean Patent Laid-Open Publication No. 10-2001-0020287 entitled "Enhanced Process of Manufacturing Nanoporous Silica Thin film" proposes a method of manufacturing a nanoporous insulating layer on a substrate.

### SUMMARY OF THE DISCLOSURE

A compound semiconductor device with a compound semiconductor thin film grown on a substrate on which spherical balls are coated is disclosed.

A method for manufacturing a compound semiconductor device is also disclosed in which spherical balls are coated on a substrate and a compound semiconductor thin film is selectively grown on the substrate having the coated spherical balls so that the entire manufacturing process can be simplified and the compound semiconductor thin film can be grown in a short amount of time.

**.** A disclosed compound semiconductor device comprises: a substrate; a plurality of spherical balls arranged on the substrate; and a compound semiconductor thin film disposed between and on the spherical balls, the thin film emitting one of ultraviolet (UV) light, visible (V) light, and infrared (IR) light.

. In one embodiment, the compound semiconductor device may further comprise a buffer layer disposed between the substrate and the compound semiconductor thin film in order to minimize the density of crystal defects in the compound semiconductor thin film by reducing a crystalline difference between the substrate and the compound semiconductor thin film. In a related embodiment, the compound semiconductor thin film may comprise a first compound semiconductor thin film and a second compound semiconductor thin film, wherein the first compound semiconductor thin film may be disposed on the buffer layer, and the second compound semiconductor thin film may be disposed between and on the spherical balls disposed on the first compound semiconductor thin film.

In another embodiment, the compound semiconductor thin film comprises: a buffer layer disposed between the substrate and the compound semiconductor thin film as described above; a plurality of spherical balls arranged on the compound semiconductor thin film; and a compound semiconductor thin film disposed between and on the spherical balls arranged on the compound semiconductor thin film.

In still another embodiment, the compound semiconductor thin film may further comprise at least one-layered compound semiconductor thin film stacked on the compound semiconductor thin film and formed of a different material from the compound semiconductor thin film.

. A disclosed method of manufacturing a compound semiconductor device comprises: forming a plurality of spherical balls; coating the spherical balls on a substrate; growing a buffer layer on the substrate on which the spherical balls are coated; selectively growing a compound semiconductor thin film between the spherical balls; growing the clusters or islands for the compound semiconductor thin film in a lateral direction such that the clusters or islands combine into the compound semiconductor thin film on the spherical balls; and continuously growing the compound semiconductor thin film to a desired thickness.

The method may further comprise: after the compound semiconductor thin film is grown to the desired thickness, forming a plurality of spherical balls; coating the spherical balls on the compound semiconductor thin film; selectively growing a compound semiconductor thin film on the compound semiconductor thin film on which the spherical balls are coated and between the spherical balls coated on the compound semiconductor thin film; and growing the compound semiconductor thin film in a lateral direction such that combine into the compound semiconductor thin film on the spherical balls coated on the compound semiconductor thin film.

**.** Another disclosed method of manufacturing a compound semiconductor device comprises: growing a buffer layer on a substrate; selectively growing a first compound semiconductor thin film on the buffer layer; growing the first compound semiconductor thin film in a lateral direction such that combine into the first compound semiconductor thin film; forming a plurality of spherical balls; coating the spherical balls on the first compound semiconductor thin film; selectively growing a second compound semiconductor thin film on the first compound semiconductor thin film and between the spherical balls; growing the second compound semiconductor thin film in a lateral direction such that combine into the second compound semiconductor thin film on the spherical balls; and continuously growing the second compound semiconductor thin film to a desired thickness.

### BRIEF DESCRIPTION OF THE DRAWINGS

The above and other features and advantages of the disclosed compound semiconductor devices and manufacturing methods will become apparent with reference to the attached drawings, wherein:

FIG. 1 graphically illustrates a lattice constant relative to an energy bandgap of a nitride semiconductor thin film;

FIG. 2 is a scanning electron microscope (SEM) photograph of a substrate on which SiO₂ spherical balls are coated according to a disclosed embodiment;

FIGS. 3 through 9 are cross-sectional views illustrating a compound semiconductor device and method of manufacturing the same according to disclosed embodiments;

FIGS. 10A through 10D are SEM photographs illustrating the operations of growing a nitride semiconductor thin film on a substrate on which SiO₂ spherical balls are coated according to a disclosed embodiment;

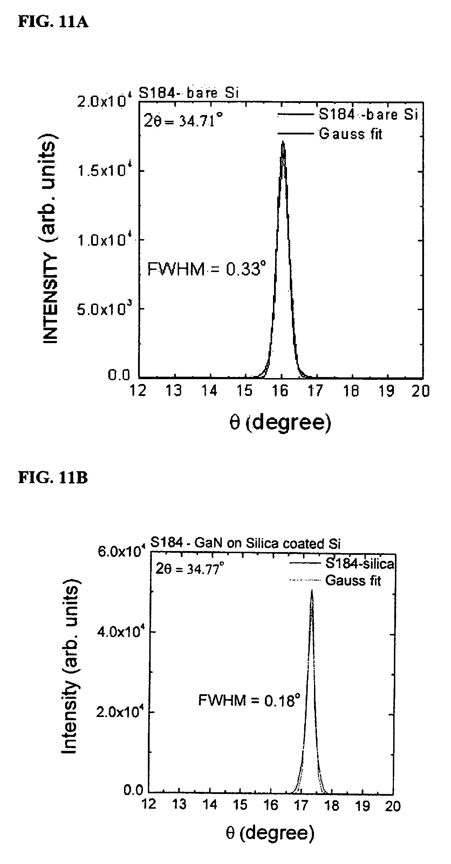

**.** FIGS. 11A and 11B are graphs showing X-ray diffraction (XRD) rocking curves for a GaN thin film; and

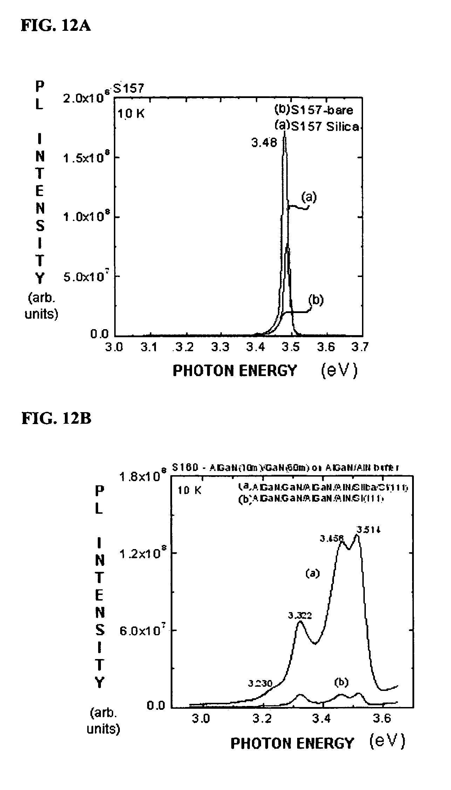

**.** FIGS. 12A and 12B are graphs showing results of measurement of low-temperature (10K) photoluminescence (PL) for a GaN thin film.

### DETAILED DESCRIPTION OF THE PRESENTLY PREFERRED EMBODIMENTS

. In the following drawings, the thickness of layers and regions may be exaggerated and other intervening layers omitted for clarity. The same reference numerals are used to denote the same elements throughout the specification.

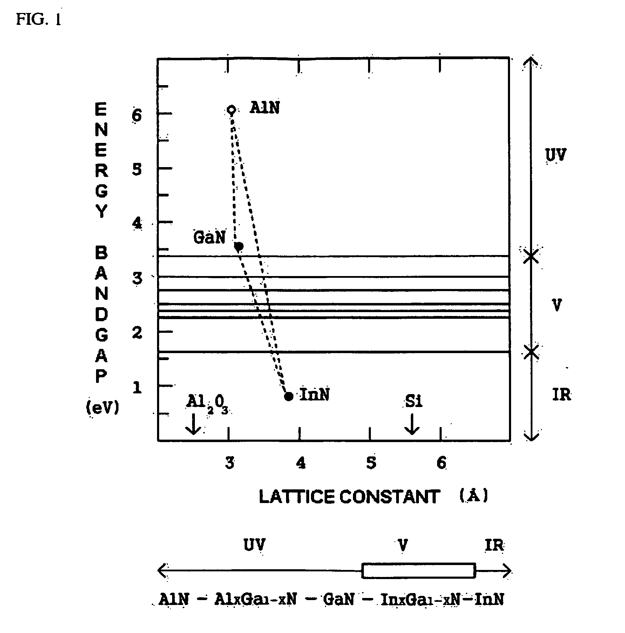

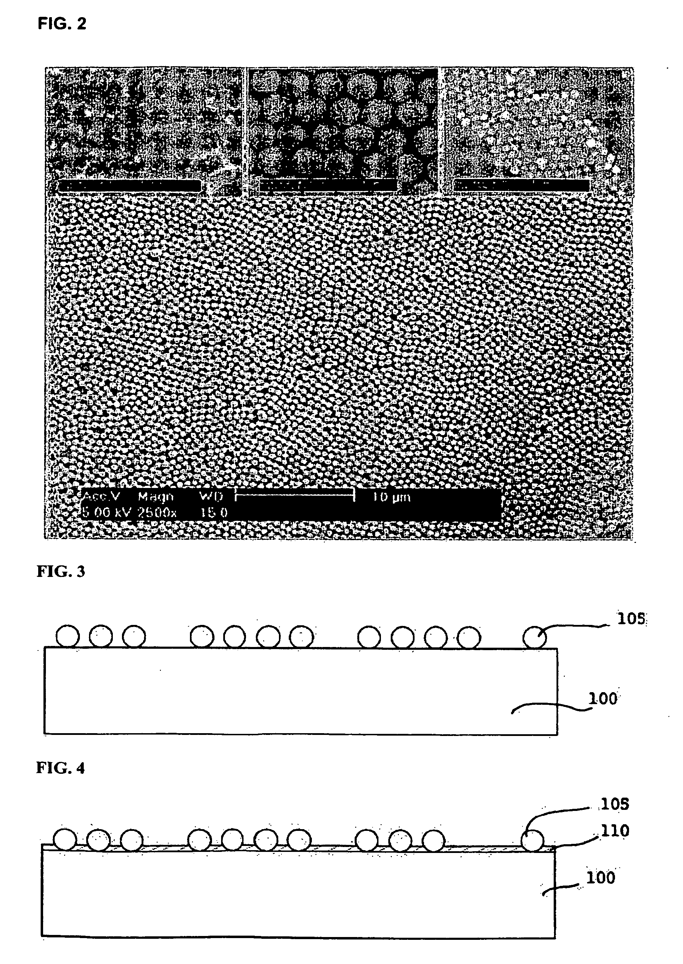

In the disclosed embodiments, a compound semiconductor thin film is grown using a selective growth process on a substrate on which spherical balls are coated. FIG. 1 is a graph showing a lattice constant relative to an energy bandgap of a nitride semiconductor thin film, and FIG. 2 is a scanning electron microscope (SEM) photograph showing a substrate on which SiO₂ spherical balls are coated according to one exemplary embodiment.

### Embodiment 1

FIGS. 3 through 7 are cross-sectional views illustrating a compound semiconductor device and method of manufacturing the same according to a first exemplary embodiment.

**.** Referring to FIG. 3, a plurality of spherical balls 105 are made and coated on a substrate 100. The spherical balls 105 maybe formed of SiO₂, Al₂O₃, TiO₂, ZrO₂, Y₂O₃-ZrO₂, CuO, Cu₂O, Ta₂O₅, PZT(Pb(Zr, Ti)O₃), Nb₂O₅, FeSO₄, Fe₃O₄, Fe₂O₃, Na₂SO₄, GeO₂, CdS, or a metal. For example, to make SiO₂ spherical balls, a first solution is made by dissolving tetraethylorthosilicate (TEOS) in anhydrous ethanol. An ammonia ethanol solution is mixed with deionized water and ethanol, thus making a second solution. Ammonia acts as a catalyst for making the spherical balls 105. The first solution is mixed with the second solution, and the mixture of the first and second solutions is stirred at a predetermined temperature for a predetermined amount of time. The spherical balls 105 are separated from the stirred mixture using a centrifugal separation process, washed using ethanol, and then redistributed in an ethanol solution. The spherical balls 105 may be made in a wide range from several nm to several tens of µm (e.g., about 10 nm to 2 µm) according to process conditions, such as growth time, temperature, and the amount of reactants. The spherical balls 105 are coated on the substrate 100 using a dip coating process or a spin coating process. FIG. 2 shows a silicon substrate on which SiO2 spherical balls are coated.

The substrate 100 may be a substrate that is formed of Al₂O₃, GaAs, spinel, InP, SiC, or Si. For example, the Al₂O₃ substrate is very stable in a high temperature environment, but its small size is not appropriate for the manufacture of large devices. The SiC substrate is also very stable in a high temperature environment and has about the same crystalline structure, lattice constant, and thermal expansion coefficient as the GaN substrate, but its price is expensive. There are a difference of 17% in lattice constant between the Si substrate and the GaN substrate and a difference of 35% in thermal expansion coefficient there between. As described above, a variety of substrates can be used for the substrate 100, and since the Si substrate enables the manufacture of large-area (about 300 mm (12 inches) or more) devices, the cost of production can be greatly reduced and the application of the devices can be dramatically expanded.

Referring to FIG. 4, the substrate 100 on which the spherical balls 105 are coated is loaded into a metal organic chemical vapor deposition (MOCVD) apparatus, and a buffer layer 110 is grown on the substrate 100. To form the buffer layer 110 using an MOCVD process, reactive precursors are injected into a reactor (i.e., the MOCVD apparatus) at predetermined flow rates through separate lines, thus causing a chemical reaction between the reactive precursors. In this process, the buffer layer 110 is formed to a desired thickness.

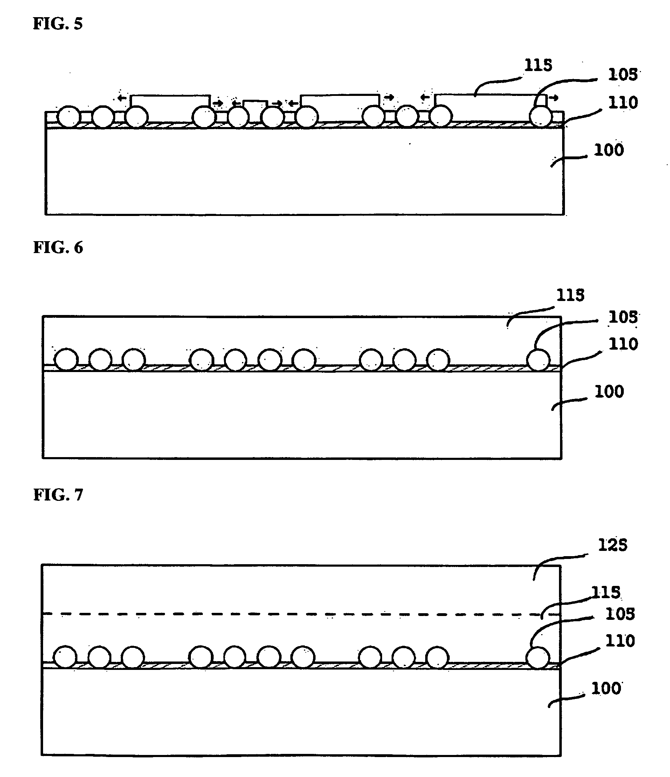

The buffer layer 110 is formed to reduce a crystalline difference between the substrate 100 and a compound semiconductor thin film which will be formed later and minimize the density of crystal defects of the compound semiconductor thin film. That is, the buffer layer 110 is used to reduce mismatch and interfacial defects between the substrate 100 and the compound semiconductor thin film. Accordingly, the buffer layer 110 may be formed of a material that has about the same crystalline characteristics as the compound semiconductor thin film and which is chemically stable. That is, the buffer layer 110 may be formed of a material, which has the same (or about the same) crystalline structure, lattice constant, or thermal expansion coefficient as the compound semiconductor thin film 115 shown in FIG. 5. Preferably, the buffer layer 110 is formed of a material, which has the same crystalline structure as the compound semiconductor thin film 115 (see FIG. 5) and makes a difference of less than 20% in lattice constant to the compound semiconductor thin film.

The buffer layer 110 may be formed of GaN, AlN, AlGaN, or a combination thereof. In this case, the reactive precursor may be TMA1, TMGa, TEGa, or GaCl₃, and a nitride source gas may be NH₃, N₂, or tertiarybutylamine(N(C₄H₉)H₂). For example, the GaN buffer layer is grown to a thickness of about 10 to 40 nm at a temperature of about 400 to 800 °C, and the AlN or AlGaN buffer layer is grown to a thickness of about 10 to 200 nm at a temperature of about 400 to 1200 °C. The buffer layer 110 may be optionally used according to the type of substrate, a growth apparatus (e.g., an MOCVD apparatus), or growth conditions.

Referring to FIG. 5, after the formation of the buffer layer 110, the compound semiconductor thin film 115 is grown on the substrate 100 on which the spherical balls 105 are coated. The compound semiconductor thin film 115 is grown between the spherical balls 105 on the buffer layer 110.

The compound semiconductor thin film 115 may be a Group III-V compound semiconductor thin film or a Group II-VI compound semiconductor thin film, which emits ultraviolet (UV) light, visible (V) light, or infrared (IR) light. The compound semiconductor thin film 115 may be formed of a nitride semiconductor material, for example, GaN, AlN, InN, or any combination thereof (e.g., Ga₁₋ₓAl_{1-y}In_{1-z}N, 0≤x, y, z≤1). GaN is a direct-transition wide bandgap semiconductor with a bandgap energy of 3.4 eV, which is appropriate for the application of a blue light emitting device or a high-temperature electronic device. When the compound semiconductor thin film 115 is deposited, In or Al is separately, simultaneously, or sequentially injected while growing a thin film formed of InN, AlN, InGaN, AlGaN, or InGaAlN, so that a bandgap of a compound semiconductor device can be controlled to 0.7 to 6.2 eV. It is known that the GaN thin film has a bandgap of 3.4 eV, the AlN thin film has a bandgap of 6.2 eV, and the InN thin film has a bandgap of 0.7 eV as shown in FIG. 1.

FIG. 1 shows lattice constants relative to energy bandgaps of several nitride semiconductor thin films. As can be seen from FIG. 1, AlN, which has a bandgap of 6.2 eV, emits UV light, AlₓGa₁₋ₓ N(0<x<1) has a smaller bandgap than AlN but emits UV light, GaN has a bandgap of 3.4 eV smaller than AlₓGa₁₋ₓN(0<x<1), InₓGa₁₋ₓN(0<x<1) has a bandgap smaller than GaN and emits V light, and InN, which has a bandgap of 0.7 eV smaller than InₓGa₁₋ₓN(0<x<1), emits IR light.

The deposition of the compound semiconductor thin film 115 on the substrate 100 on which the spherical balls 105 are coated can be performed using, for example, an MOCVD process, a molecular beam epitaxy (MBE) process, or a hydride vapor phase epitaxy (HVPE) process.

One method of forming the compound semiconductor thin film 115 using the MOCVD process is as follows. Initially, the substrate 100 on which the spherical balls 105 are coated is loaded into a reactor, and reactive precursors are injected into the reactor using a carrier gas. Thereafter, a chemical reaction between the reactive precursors is caused at predetermined temperature and pressure, thus growing the compound semiconductor thin film 115. When the compound semiconductor thin film 115 is a nitride-based thin film, the reactive precursor may be TMA1, TMGa, TEGa, or GaCl₃, and a nitride source gas may be NH₃, N₂, or tertiarybutylamine(N(C₄H₉)H₂)

The reactor may be maintained at a temperature of 900 to 1150 °C and at a pressure of 1.3·10⁻³ Pa to 270 kPa (10-5 to 2000 mmHg). The compound semiconductor thin film 115 may be grown in the form of clusters or islands on the substrate 100 on which the spherical balls 105 are grown. When the compound semiconductor thin film 115 has its own coherence stronger than a combination between the substrate 100 and the compound semiconductor thin film 115, small clusters are formed and adsorbed onto the substrate 100 to form islands. Finally, the clusters or islands combine into the continuous compound semiconductor thin film 115. In this case, the thickness of the compound semiconductor thin film 115 may be appropriately controlled according to the quality level or specification as required.

. A process of forming a GaN thin film using an MOCVD method can be expressed as shown in the following reaction (1):

Ga(CH₃)₃+NH₃→ Ga(CH₃)₃·NH₃ (1)

TMGa and NH₃ are injected into the reactor, thus generating Ga(CH₃)₃·NH₃.

Ga(CH₃)₃ ·NH₃ is pyrolyzed on the substrate 100 so that a GaN thin film can be obtained by a reaction as shown in the following reaction (2):

Ga(CH₃)₃·NH₃→GaN+nCH₄+1/2(3-n)H₂ (2)

Referring to FIG. 6, the clusters or islands grown between the spherical balls 105 are continuously grown in a lateral direction and thus, combine into the continuous compound semiconductor thin film 115. That is, the clusters or islands adsorbed onto the substrate 100 are continuously grown and combine with one another, so that the compound semiconductor thin film 115 can have a continuous shape.

Referring to FIG. 7, a growth process is further performed on the continuous compound semiconductor thin film 115, which is selectively grown on the spherical balls 105, until a compound semiconductor thin film 125 is formed to a desired thickness. The compound semiconductor thin film 125 may be formed of the same material as or a different material from the compound semiconductor thin film 115. For example, when the compound semiconductor thin film 115 is a GaN thin film, the compound semiconductor thin film may be an AlGaN thin film. Of course, the compound semiconductor thin film 125 may include at least one layer that is formed of the same material as or a different material from the compound semiconductor thin film 115.

### Embodiment 2

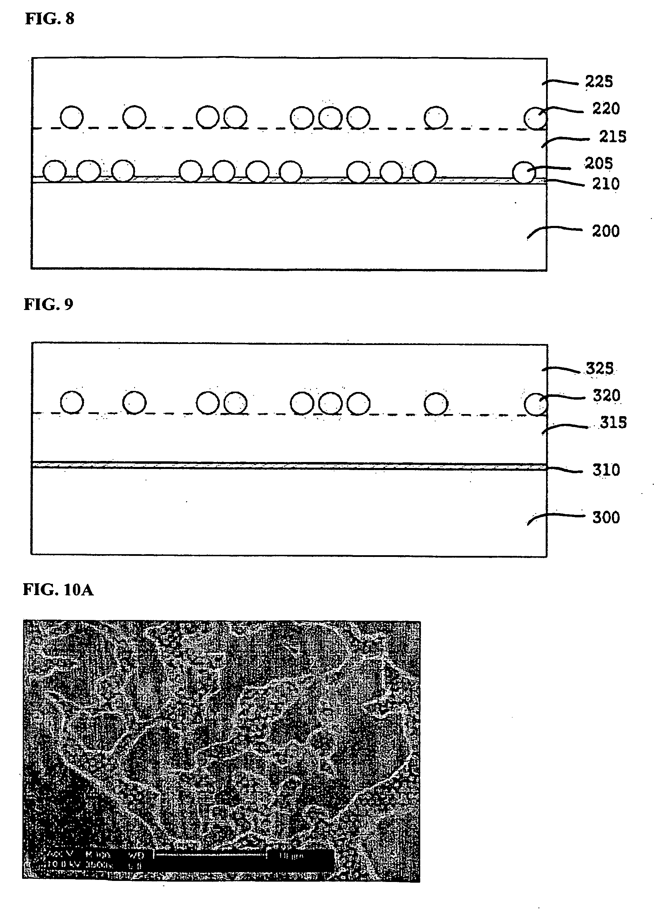

FIG. 8 is a cross-sectional view illustrating a compound semiconductor thin film and method of manufacturing the same according to a second exemplary embodiment.

Referring to FIG. 8, the processes described with reference to FIGS. 3 through 6 are performed to form a compound semiconductor thin film. That is, spherical balls 205 are made and coated on a substrate 200, a buffer layer 210 is grown, and a compound semiconductor thin film 215 is grown between the spherical balls 205 on the buffer layer 210.

The substrate 200 having the compound semiconductor thin film 215 is taken out of a reactor. Thereafter, spherical balls 220 with a size of several nm to several tens of µm are coated on the first compound semiconductor thin film 215. Next, the substrate 200 having the spherical balls 220 is loaded again into the reactor, and a second compound semiconductor thin film 225 is grown on the first compound semiconductor thin film 215 having the spherical balls 220.

### Embodiment 3

FIG. 9 is a cross-sectional view illustrating a compound semiconductor device and method of manufacturing the same according to a third exemplary embodiment.

**.** Referring to FIG. 9, the processes described with reference to FIGS. 4 through 6 are performed, thus a buffer layer and a compound semiconductor thin film are grown on a substrate. That is, a buffer layer 310 is grown on a substrate 300, and then a compound semiconductor thin film 315 is grown on the buffer layer 310.

The substrate 300 on which the compound semiconductor thin film 315 is formed is unloaded from a reactor. Thereafter, spherical balls 320 with a size of several nm to several tens of µm are coated on the compound semiconductor thin film 315 in the same manner as described with reference to FIG. 3, and a compound semiconductor thin film 325 is grown on the compound semiconductor thin film 315 on which the spherical balls 320 are coated.

Like in the above embodiments, the method of growing a compound semiconductor thin film using a selective growth process on a substrate on which spherical balls are grown can simplify the entire process in comparison to a conventional ELO process, enables the growth of a high-quality compound semiconductor thin film, and also greatly shorten the time taken to grow the compound semiconductor thin film.

Also, in the above embodiments, a thin film can be deposited while injecting different kinds of materials (i.e., at least one selected from the group consisting of Si, Ge, Mg, Zn, O, Se, Mn, Ti, Ni, and Fe) into a reactor according to purposes, so that a compound semiconductor thin film to which a different kind of material is added can be obtained. These different kinds of materials may be optionally added in order to change the electrical, optical, or magnetic properties of the compound semiconductor thin film. The different kinds of materials can be added using an in-situ doping process, an ex-situ doping process, or an ion implantation process. The in-situ doping process is to add a different kind of material during the growth of a thin film, whereas the ex-situ doping process is to inject a different kind of material into a compound semiconductor thin film using a thermal or plasma treatment process after the compound semiconductor thin film is grown. Also, in the ion implantation process, a different kind of material is accelerated and collides with a compound semiconductor thin film so that the different kind of material is implanted into the thin film.

In another approach, after a compound semiconductor thin film is formed on a substrate on which spherical balls are coated, a thick compound semiconductor layer may be deposited using an HVPE technique on the compound semiconductor thin film that serves as a substrate. The HVPE technique is one of vapor deposition methods, in which gases are supplied to a substrate so that crystals are grown by a reaction between the gases. Once the thick compound semiconductor layer is formed using the HVPE technique, the compound semiconductor thin film used as the substrate is cut or a region except the thick compound semiconductor layer is removed by a polishing or grinding process. Then, only a uniform and good-quality compound semiconductor layer, which is grown on the substrate, can be selected and used.

A method of forming the foregoing thick compound semiconductor layer (e.g., a GaN thick layer) on a compound semiconductor thin film using an HVPE technique is as follows. Initially, a container containing Ga is loaded into a reactor and heated using a heater installed around the container to form a Ga solution. A reaction between the Ga solution and HCl occurs, thus generating a GaCl gas. This reaction can be expressed as shown in the following reaction (3):

Ga(1)+ HCl(g)→ GaCl(g)+1/2H₂ (g) (3)

The GaCl gas reacts with NH₃, thus producing a GaN layer. This reaction can be expressed as shown in the following reaction (4):

GaCl(g)+NH₃→GaN+HCl(g)+H₂ (4)

The unreacted gas is exhausted by a reaction expressed in the following reaction (5):

HCl(g)+NH₃→NH₄Cl(g) (5)

The HVPE technique enables the growth of a thick layer at a high rate of about 100 µm/hr and results in high productivity.

### Experimental Example 1

To make spherical balls, tetraethylorthosilicate (TEOS) of 0.17mol (7.747ml) was dissolved in anhydrous ethanol (12.253 ml), thus making a first solution. An ammonia ethanol solution of 2.0mol (100 ml) was mixed with deionized water of 7.5 mol (27 ml) and ethanol (53 ml), thus making a second solution. The first and second solutions were mixed to form a mixture having a total volume of 200 ml. The mixture was stirred at a temperature of about 30 °C for 5 hours. Then, the spherical balls were separated from the stirred mixture through a centrifugal separation process at 12000 rpm, washed using ethanol, and redistributed in an ethanol solution, thereby making the spherical balls. In this case, the spherical balls have an average diameter of about 0.5 µm (i.e. 500 nm) as shown in the SEM photograph of FIG. 2. The spherical balls can be made in a wide range from 10 nm to 2 µm according to process conditions, such as growth time, temperature, and the amount of reactants.

The SiO₂ spherical balls with a size of 0.5 µm were coated on a Si substrate (e.g., a Si substrate that is sliced in plane (111)) using an apparatus, such as a dip coater or a spin coater. As a specific example, the SiO₂ balls contained in the ethanol solution were dropped on the Si substrate using a syringe and coated on the Si substrate for 5 to 120 seconds at a rate of 1000 to 3500 rpm using a spin coater. The density of the SiO₂ balls can be controlled by repeating the coating process several times.

After the SiO₂ spherical balls were coated on the Si substrate, the resultant structure was loaded into an MOCVD apparatus and an A1N buffer layer was grown at a temperature of 1150 °C for 10 minutes to have a thickness of 100 nm. In more detail, TMA1 gas and NH₃ gas were injected at flow rates of 30 and 1500 sccm, respectively, through separate lines into a reactor. In this case, H₂ gas was used as a carrier gas. While the reactor was being maintained at a pressure of 13 kPa (100 torr) and a temperature of 1150 °C, a chemical reaction between the reactive precursors (TMAl and NH₃ gases) was caused for 10 minutes, thus the AlN buffer layer with a thickness of about 70 to 100 nm was grown between the 500-nm SiO₂ balls on the Si substrate, as shown in FIG. 4.

After the AlN buffer layer was formed, the substrate was cooled off to a temperature of 1060 °C, and a GaN thin film was grown between the SiO₂ spherical balls and on the SiO₂ spherical balls (refer to FIGS. 10A through 10D). In more detail, to form the GaN thin film, TMGa gas and NH₃ gas were injected at flow rates of 4.2 and 1500 sccm, respectively, through separate lines into the reactor, and H₂ gas was used as a carrier gas. While the reactor was being maintained at a pressure of about 13 kPa (100 torr) and a temperature of 1060 °C, a chemical reaction between the reactive precursors (TMGa and NH₃ gases) was caused, thus the GaN thin film was grown as shown in FIG. 5. As explained above with reference to FIGS. 6 and 7, a selective growth process was further performed so that GaN crystals between the SiO₂ spherical balls were grown in a lateral direction for 40 minutes or more. As a result, a uniform GaN thin film could be obtained. In this case, the growth rate of the GaN thin film was about 1 µm/hour.

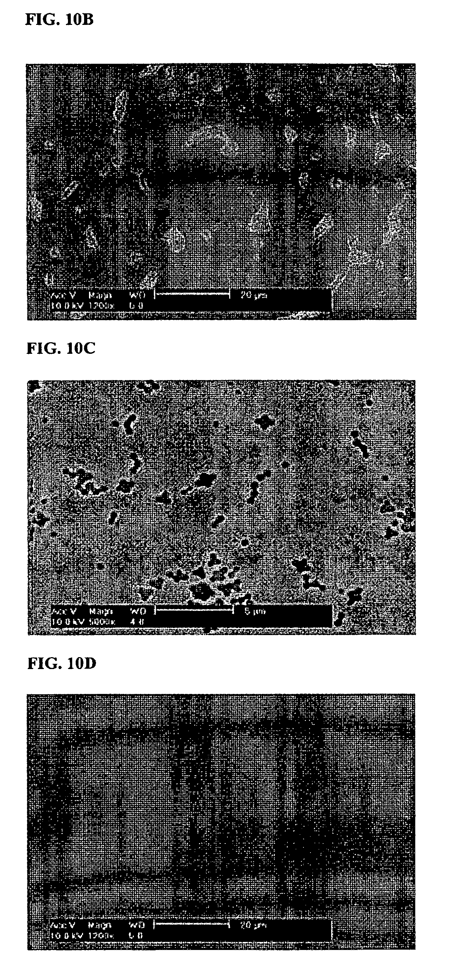

FIGS. 10A through 10D are SEM photographs illustrating the operations of growing a nitride semiconductor thin film on a substrate on which SiO₂ spherical balls are coated according to an exemplary embodiment of the present invention. Specifically, FIG. 10A is a SEM photograph showing a case where a GaN thin film is grown for about 30 minutes, FIG. 10B is a SEM photograph showing a case where the GaN thin film is grown for about 50 minutes, FIG. 10C is a SEM photograph showing the GaN thin film is grown for about 60 minutes, and FIG. 10D is a SEM photograph showing a case where the GaN thin film is grown for more than 60 minutes until the GaN thin film completely covers the SiO₂ balls.

### Experimental Example 2

In the present exemplary example, SiO₂ spherical balls were coated on a Si substrate like in the first Experimental example, and then a buffer layer formed of AlN/AlGaN was formed. In the case of the AlN buffer layer, TMAl gas and NH₃ gas were injected at flow rates of 30 and 1500 sccm, respectively, through separate lines into a reactor using an H₂ carrier gas. While the reactor was being maintained at a pressure of 13 kPa (100 torr) and a temperature of about 1150 °C, a chemical reaction between the reactive precursors (TMAl and NH₃) was caused for 10 minutes, thus the AlN layer was grown. Also, in the case of the AlGaN buffer layer, TMAl gas, TMGa gas, and NH₃ gas were injected at flow rates of 10, 4.2, and 1500 sccm, respectively, through separate lines into the reactor using an H₂ carrier gas. While the reactor was being maintained at a pressure of 13 kPa (100 torr) and a temperature of 1100 °C, a chemical reaction between the reactive precursors (TMA1, TMGa, and NH₃) was caused for 10 minutes, thus the AlGaN buffer layer was grown.

After the AlN/AlGaN buffer layer was formed, a GaN thin film was grown for 60 minutes like in the first Experimental example. Thereafter, TMA1 gas, TMGa gas, and NH₃ gas were injected at flow rates of 10, 4.2, and 1500 sccm, respectively, through separate lines into the reactor using an H₂ carrier gas. Then, while the reactor was being maintained at a pressure of 13 kPa (100 torr) and a temperature of about 1100 °C, a chemical reaction between the reactive precursors (TMAl, TMGa, and NH3) was carried out for 10 minutes, thus an AlGaN thin film was grown on the GaN thin film.

FIGS. 11A and 11B are graphs showing X-ray diffraction (XRD) rocking curves for a GaN thin film. The XRD is used to analyze the crystalline structure of a thin film based on a diffraction peak obtained by measuring values for a rocking curve. Specifically, FIG. 11A is an XRD rocking curve in a case where a GaN thin film is grown on a Si substrate on which SiO₂ balls are not coated, and FIG. 11B is an XRD rocking curve in a case where a GaN thin film is grown for 90 minutes on a Si substrate on which 500-nm SiO₂ balls are coated according to the above-described first Experimental example.

Referring to FIGS. 11A and 11B, full width half maximum (FWHM) of the XRD rocking curve of the GaN thin film grown on the Si substrate on which the SiO₂ spherical balls are not coated was 0.33°, while FWHM of the XRD rocking curve of the GaN thin film selectively grown on the Si substrate on which the SiO₂ spherical balls are coated was 0.18°. From the above result, it can be seen that the GaN thin film, which is selectively grown on the Si substrate on which the SiO₂ balls are coated, is much superior in quality to the GaN thin film grown on the Si substrate on which no SiO₂ balls are coated.

**.** FIGS. 12A and 12B are graphs showing results of measurement of low-temperature (10K) photoluminescence (PL) for a GaN thin film. The PL of the GaN layer was measured using the 325-nm wavelength of a He-Cd laser as a light source, and the optical characteristic of a material was appreciated by the recombination of electrons and holes within a bandgap. In FIG. 12A, curve (a) exhibits a PL peak in a case where a GaN thin film was grown for 60 minutes on a Si substrate on which 500-nm SiO₂ balls were coated according to the above-described first Experimental example, and curve (b) exhibits a PL peak in a case where a GaN thin film was grown for 60 minutes on a Si substrate on which SiO₂ balls were not coated. In FIG. 12B, curve (a) exhibits a PL peak in a case where a GaN thin film is grown on a Si substrate on which 500-nm SiO₂ balls are coated and an AlGaN thin film was grown on the GaN thin film according to the second Experimental example, and curve (b) exhibits a PL peak in a case where a GaN thin film was grown for 60 minutes on a silicon substrate on which SiO₂ balls are not coated.

Referring to FIG. 12A, which shows PL measurements obtained at a low temperature of 10K, the PL intensity of the GaN thin film that was selectively grown on the silicon substrate on which SiO₂ balls were coated is more than twice as high as that of the GaN thin film that was grown by a conventional method on the silicon substrate on which no SiO₂ balls are coated.

Accordingly, it can be confirmed that compound semiconductor thin films, which is selectively grown on a substrate on which spherical balls are coated according to the disclosed exemplary embodiments, are of excellent quality as shown in FIGS. 12A and 12B.

**.** Thus, a GaN thin film is selectively grown on a substrate on which spherical balls are coated. More specifically, the spherical balls are coated on the substrate, the substrate is loaded into an MOCVD apparatus, a buffer layer is grown on the substrate, and then a compound semiconductor thin film is selectively grown between the spherical balls. In this method, a high-quality GaN thin film can be grown in a shorter amount of time in comparison to a conventional ELO method.

## Claims

1. A compound semiconductor device comprising:
a substrate;
a first plurality of spherical balls arranged on top of the substrate; and
a first compound semiconductor thin film disposed between and on the spherical balls, the compound semiconductor thin film emitting one of ultraviolet (UV) light, visible (V) light, and infrared (IR) light,
wherein the spherical balls are formed of a material selected from the group consisting of SiO2, Al2O3, TiO2, ZrO2, Y2O3-ZrO2, CuO, Cu2O, Ta2O5, PZT(Pb(Zr, Ti)03), Nb2O5, FeS04, Fe3O4, Fe2O3, Na2SO4, Ge02, CdS, and a metal.

2. The device according to claim 1, further comprising:
a buffer layer disposed between the substrate and the first compound semiconductor thin film to minimize a density of crystal defects of the first compound semiconductor thin film by reducing the difference in lattice constant to the first compound semiconductor thin film.

3. The device according to claim 1, further comprising:
a buffer layer disposed between the substrate and the first compound semiconductor thin film to minimize a density of crystal defects of the first compound semiconductor thin film by reducing the difference in lattice constant to first compound semiconductor thin film;
a second plurality of spherical balls arranged on the first compound semiconductor thin film; and
a second compound semiconductor thin film disposed between and on the second plurality of spherical balls arranged on the first compound semiconductor thin film, the second compound semiconductor thin film emitting one of ultraviolet (UV) light, visible (V) light, and infrared (IR) light.

4. The device according to claim 1, further comprising:
a buffer layer disposed between the substrate and the first compound semiconductor thin film to minimize a density of crystal defects of the first compound semiconductor thin film by reducing the difference in lattice constant to the first compound semiconductor thin film,
the first plurality of spherical balls being disposed on the first compound semiconductor thin film,
a second compound semiconductor thin film, the second compound semiconductor thin film being disposed between and on the spherical balls disposed on the first compound semiconductor thin film.

5. The device according to claim 1, further comprising a second compound semiconductor thin film stacked on the first compound semiconductor thin film and the second compound semiconductor thin film is formed from a different material than the first compound semiconductor thin film.

6. The device according to claim 2, wherein the buffer layer is formed of a material selected from the group consisting of GaN, AlN, AlGaN, and combinations thereof.

7. The device according to claim 6, wherein the buffer layer and the first compound semiconductor thin film have the same crystalline structure, and have a difference in lattice constant of less than 20 %.

8. The device according to claim 1, wherein each of the spherical balls has a diameter ranging from 10 nm to 2 µm.

9. The device according to claim 1, wherein the compound semiconductor thin film is formed of a material selected from the group consisting of GaN, AIN, InN, and combinations thereof (Ga₁₋ₓAl_{1-y}In_{1-z}N, 0≤x, y and z≤1).

10. The device according to claim 1, wherein the compound semiconductor thin film further contains at least one material selected from the group consisting of Si, Ge, Mg, Zn, O, Se, Mn, Ti, Ni, and Fe.

11. The device according to claim 1, wherein the substrate comprises a material selected from the group consisting of Al₂O₃, GaAs, spinel, InP, SiC, and Si.

12. A method of manufacturing a compound semiconductor device, comprising:
forming a plurality of spherical balls;
coating the spherical balls onto a substrate;
growing a buffer layer on the substrate on which the spherical balls are coated;
selectively growing a compound semiconductor thin film between the spherical balls;
growing the compound semiconductor thin film in a lateral direction so that it grows on the spherical balls; and
continuously growing the compound semiconductor thin film to a desired thickness.

13. The method according to claim 12, further comprising:
after continuously growing the compound semiconductor thin film to the desired thickness,
forming a plurality of spherical balls;
coating the spherical balls onto the compound semiconductor thin film;
selectively growing another compound semiconductor thin film on the compound semiconductor thin film on which the spherical balls are coated and between the spherical balls; and
growing for the compound semiconductor thin film in a lateral direction and on the spherical balls.

14. A method of manufacturing a compound semiconductor device, comprising:
growing a buffer layer on a substrate;
selectively growing a first compound semiconductor thin film on the buffer layer;
growing clusters or islands for the first compound semiconductor thin film in a lateral direction such that combine into the first compound semiconductor thin film;
forming a plurality of spherical balls;
coating the spherical balls onto the first compound semiconductor thin film;
selectively growing a second compound semiconductor thin film on the first compound semiconductor thin film and between the spherical balls;
growing for the second compound semiconductor thin film in a lateral direction and on the spherical balls; and
continuously growing the second compound semiconductor thin film to a desired thickness.

15. The method according to claim 12, wherein each of the spherical balls has a diameter in the range of from 10 nm to 2 µm.

16. The method according to claim 12, wherein the spherical balls are formed of a material selected from the group consisting of SiO₂, Al₂O₃, TiO₂, ZrO₂, Y₂O₃-ZrO₂, CuO, Cu₂O, Ta₂O₅, PZT(Pb(Zr, Ti)O₃), Nb₂O₅, FeSO₄, Fe₃O₄, Fe₂O₃, Na₂SO₄, GeO₂, CdS, and a metal.

17. The method according to claim 12, wherein the forming of the spherical balls comprises:
making a first solution by dissolving tetraethylorthosilicate (TEOS) in anhydrous ethanol;
making a second solution by mixing an ammonia ethanol solution with deionized water and ethanol;
mixing the first and second solutions and stirring the mixture of the first and second solutions at a predetermined temperature for a predetermined amount of time;
separating spherical balls from the stirred mixture using a centrifugal separation process; and
forming the spherical balls by distributing the separated spherical balls in an ethanol solution.

18. The method according to claim 12, wherein the buffer layer is formed of a material selected from the group consisting of GaN, AlN, AlGaN, and combinations thereof with a thickness in the range of from 10 to 200 nm, to minimize a density of crystal defects of the compound semiconductor thin film by reducing the difference in lattice constant to the compound semiconductor thin film.

19. The method according to claim 12, wherein the growing of the buffer layer comprises:
maintaining a reactor at constant pressure and temperature;
injecting reactive precursors at predetermined flow rates through separate lines into the reactor; and
growing a buffer layer to a desired thickness by causing a chemical reaction between the reactive precursors in the reactor.

20. The method according to claim 19, wherein the buffer layer is grown while the reactor is being maintained at a temperature in a range of from 400 to 1200 °C.

21. The method according to claim 19, wherein the reactive precursors include a first reactive precursor, which is selected from the group consisting of TMA1, TMGa, TEGa, and GaCl₃, and a second reactive precursor, which is selected from the group consisting of NH₃, N₂, and tertiarybutylamine(N(C₄H₉)H₂), and the buffer layer is formed of one selected from the group consisting of GaN, AlN, AlGaN, and combinations thereof.

22. The method according to claim 12, wherein the selectively growing of the compound semiconductor thin film between the spherical balls comprises:
maintaining a reactor at constant pressure and temperature;
injecting reactive precursors at predetermined flow rates through separate lines into a reactor; and
growing a compound semiconductor thin film by causing a chemical reaction between the reactive precursors in the reactor.

23. The method according to claim 22, wherein the compound semiconductor thin film is grown while the reactor that is maintained at a temperature in a range of from 900 to 1150 °C.

24. The method according to claim 22, wherein the reactive precursors include a first reactive precursor, which is selected from the group consisting of TMA1, TMGa, TEGa, and GaCl₃, and a second reactive precursor, which is selected from the group consisting of NH₃, N₂, and tertiarybutylamine(N(C₄H₉)H₂), and the compound semiconductor thin film is formed of a material selected from the group consisting of GaN, AlN, AlGaN, and combinations thereof.

25. The method according to claim 12, wherein the compound semiconductor thin film further contains at least one material selected from the group consisting of Si, Ge, Mg, Zn, O, Se, Mn, Ti, Ni, and Fe.

26. The method according to claim 12, wherein the substrate is formed of a material selected from the group consisting of Al₂O₃, GaAs, spinel, InP, SiC, and Si.

## Patentansprüche

1. Verbindungshalbleiterbauelement, aufweisend
ein Substrat
eine erste Vielzahl runder Kugeln, die auf der Oberseite des Substrats angeordnet ist; und
eine erste Verbindungshalbleiterdünnschicht, die zwischen und auf den runden Kugeln angeordnet ist, wobei die Verbindungshalbleiterdünnschicht entweder Ultraviolett-(UV-) Licht, sichtbares (V) Licht oder Infrarot- (IR-) Licht emittiert,
wobei die runden Kugeln aus einem Material gebildet sind, das ausgewählt ist aus der Gruppe, bestehend aus SiO₂, Al₂O₃, TiO₂, ZrO₂, Y₂O₃-ZrO₂, CuO, Cu₂O, Ta₂O₅, PZT(Pb(Zr, Ti)O₃), Nb₂O₅, FeSO₄, Fe₃O₄, Fe₂O₃, Na₂SO₄, GeO₂, CdS und einem Metall.

2. Bauelement nach Anspruch 1, ferner aufweisend:
eine Pufferschicht, die zwischen dem Substrat und der ersten
Verbindungshalbleiterdünnschicht angeordnet ist, um eine Dichte der Kristalldefekte der ersten Verbindungshalbleiterdünnschicht zu minimieren, indem sie die Differenz der Gitterkonstante zu der ersten Verbindungshalbleiterdünnschicht reduziert.

3. Bauelement nach Anspruch 1, ferner aufweisend:
eine Pufferschicht, die zwischen dem Substrat und der ersten
Verbindungshalbleiterdünnschicht angeordnet ist, um eine Dichte der Kristalldefekte der ersten Verbindungshalbleiterdünnschicht zu minimieren, indem sie die Differenz der Gitterkonstante zu der ersten Verbindungshalbleiterdünnschicht reduziert;
eine zweite Vielzahl runder Kugeln, die auf der ersten
Verbindungshalbleiterdünnschicht angeordnet ist; und
eine zweite Verbindungshalbleiterdünnschicht, die zwischen und auf der zweiten Vielzahl der auf der ersten Verbindungshalbleiterdünnschicht angeordneten runden Kugeln angeordnet ist, wobei die zweite Verbindungshalbleiterdünnschicht entweder Ultraviolett- (UV-) Licht, sichtbares (V) Licht oder Infrarot- (IR-) Licht emittiert.

4. Bauelement nach Anspruch 1, ferner aufweisend:
eine Pufferschicht, die zwischen dem Substrat und der ersten
Verbindungshalbleiterdünnschicht angeordnet ist, um eine Dichte der Kristalldefekte der ersten Verbindungshalbleiterdünnschicht zu minimieren, indem sie die Differenz der Gitterkonstante zu der ersten Verbindungshalbleiterdünnschicht reduziert,
wobei die erste Vielzahl der runden Kugeln auf der ersten
Verbindungshalbleiterdünnschicht angeordnet ist,
eine zweite Verbindungshalbleiterdünnschicht, wobei die zweite Verbindungshalbleiterdünnschicht zwischen und auf den auf der ersten Verbindungshalbleiterdünnschicht angeordneten runden Kugeln angeordnet ist.

5. Bauelement nach Anspruch 1, ferner aufweisend eine zweite Verbindungshalbleiterdünnschicht, die auf der ersten Verbindungshalbleiterdünnschicht gestapelt ist, wobei die zweite Verbindungshalbleiterdünnschicht aus einem anderen Material als die erste Verbindungshalbleiterdünnschicht gebildet ist.

6. Bauelement nach Anspruch 2, wobei die Pufferschicht aus einem Material gebildet ist, das ausgewählt ist aus der Gruppe, bestehend aus GaN, AlN, AlGaN und Kombinationen derselben.

7. Bauelement nach Anspruch 6, wobei die Pufferschicht und die erste Verbindungshalbleiterdünnschicht die gleiche Kristallstruktur aufweisen und die Differenz der Gitterkonstanten weniger als 20% beträgt.

8. Bauelement nach Anspruch 1, wobei jede runde Kugel einen Durchmesser in einem Bereich von 10 nm bis 2 µm besitzt.

9. Bauelement nach Anspruch 1, wobei die Verbindungshalbleiterdünnschicht aus einem Material gebildet ist, das ausgewählt ist aus der Gruppe, bestehend aus GaN, AIN, InN und Kombinationen derselben (Ga₁₋ₓAl_{1-y}In_{1-z}N, 0 ≤x, y und z ≤ 1).

10. Bauelement nach Anspruch 1, wobei die Verbindungshalbleiterdünnschicht wenigstens ein Material enthält, das ausgewählt ist aus der Gruppe, bestehend aus Si, Ge, Mg, Zn, O, Se, Mn, Ti, Ni und Fe.

11. Bauelement nach Anspruch 1, wobei das Substrat ein Material aufweist, das ausgewählt ist aus der Gruppe, bestehend aus Al₂O₃, GaAs, Spinell, InP, SiC und Si.

12. Verfahren zum Herstellen eines Verbindungshalbleiterbauelements, umfassend:
Bilden einer Vielzahl runder Kugeln;
Aufbringen der runden Kugeln auf ein Substrat;
Aufwachsen einer Pufferschicht auf das Substrat, auf welches die runden Kugeln aufgebracht wurden;
selektives Aufwachsen einer Verbindungshalbleiterdünnschicht zwischen die runden Kugeln;
Aufwachsen der Verbindungshalbleiterdünnschicht in eine Querrichtung, so dass sie auf die runden Kugeln aufwächst; und
kontinuierliches Aufwachsen der Verbindungshalbleiterdünnschicht bis zu einer gewünschten Dicke.

13. Verfahren nach Anspruch 12, ferner umfassend:
nach dem kontinuierlichen Aufwachsen der Verbindungshalbleiterdünnschicht bis zu einer gewünschten Dicke,
Bilden einer Vielzahl runder Kugeln;
Aufbringen der runden Kugeln auf die Verbindungshalbleiterdünnschicht;
selektives Aufwachsen einer weiteren Verbindungshalbleiterdünnschicht auf die Verbindungshalbleiterdünnschicht, auf welche die runden Kugeln aufgebracht wurden,
und zwischen die runden Kugeln; und
Aufwachsen der Verbindungshalbleiterdünnschicht in einer Querrichtung und auf die runden Kugeln.

14. Verfahren zum Herstellen eines Verbindungshalbleiterbauelements, umfassend:
Aufwachsen einer Pufferschicht auf ein Substrat;
selektives Aufwachsen einer ersten Verbindungshalbleiterdünnschicht auf die Pufferschicht;
Aufwachsen von Clustern oder Inseln für die erste Verbindungshalbleiterdünnschicht in eine Querrichtung, so dass sie sich zu der ersten Verbindungshalbleiterdünnschicht vereinen;
Bilden einer Vielzahl runder Kugeln;
Aufbringen der runden Kugeln auf die erste Verbindungshalbleiterdünnschicht;
selektives Aufwachsen einer zweiten Verbindungshalbleiterdünnschicht auf die erste Verbindungshalbleiterdünnschicht und zwischen die runden Kugeln;
Aufwachsen der zweiten Verbindungshalbleiterdünnschicht in eine Querrichtung und
auf die runden Kugeln; und
kontinuierliches Aufwachsen der zweiten Verbindungshalbleiterdünnschicht bis zu einer gewünschten Dicke.

15. Verfahren nach Anspruch 12, wobei jede runde Kugel einen Durchmesser in einem Bereich von 10 nm bis 2 µm besitzt.

16. Verfahren nach Anspruch 12, wobei die runden Kugeln aus einem Material gebildet sind, das ausgewählt ist aus der Gruppe, bestehend aus SiO₂, Al₂O₃, TiO₂, ZrO₂, Y₂O₃-ZrO₂, CuO, Cu₂O, Ta₂O₅, PZT(Pb(Zr, Ti)O₃), Nb₂O₅, FeSO₄, Fe₃O₄, Fe₂O₃, Na₂SO₄, GeO₂, CdS und einem Metall.

17. Verfahren nach Anspruch 12, wobei das Bilden der runden Kugeln umfasst:
Herstellen einer ersten Lösung durch Lösen von Tetraethylorthosilikat (TEOS) in wasserfreiem Ethanol;
Herstellen einer zweiten Lösung durch Mischen einer Ammoniak-Ethanol-Lösung mit deionisiertem Wasser und Ethanol;
Mischen der ersten und der zweiten Lösung und Rühren der Mischung aus der ersten und der zweiten Lösung bei einer vorgegebenen Temperatur für eine vorgegebene Zeitdauer;
Abtrennen der runden Kugeln von der gerührten Mischung mittels eines Zentrifugal-Abtrennungsverfahrens; und
Bilden der runden Kugeln durch Verteilen der abgetrennten runden Kugeln in einer Ethanol-Lösung.

18. Verfahren nach Anspruch 12, wobei die Pufferschicht aus einem Material gebildet ist, das ausgewählt ist aus der Gruppe, bestehend aus GaN, AIN, AlGaN und Kombinationen derselben und eine Dicke in einem Bereich von 10 bis 200 nm besitzt, um eine Dichte der Kristalldefekte der Verbindungshalbleiterdünnschicht zu minimieren, indem sie die Differenz der Gitterkonstante zu der Verbindungshalbleiterdünnschicht reduziert.

19. Verfahren nach Anspruch 12, wobei das Aufwachsen der Pufferschicht umfasst:
Halten eines Reaktors auf einem konstanten Druck und bei einer konstanten Temperatur;
Injizieren reaktiver Precursor mit vorgegebenen Flussraten durch getrennte Leitungen in den Reaktor; und
Aufwachsen einer Pufferschicht bis zu einer gewünschten Dicke durch Anstoßen einer chemischen Reaktion zwischen den reaktiven Precursom im Reaktor.

20. Verfahren nach Anspruch 19, wobei die Pufferschicht aufgewachst wird, während der Reaktor bei einer Temperatur in einem Bereich von 400 bis 1200 °C gehalten wird.

21. Verfahren nach Anspruch 19, wobei die reaktiven Precursor einen ersten reaktiven Precursor, der ausgewählt ist aus der Gruppe, bestehend aus TMA1, TMGa, TEGa und GaCl₃, und einen zweiten reaktiven Precursor, der ausgewählt ist aus der Gruppe, bestehend aus NH₃, N₂ und tertiärem Butylamin (N(C₄H₉)H₂), umfassen, und wobei die Pufferschicht aus einem Material gebildet ist, das ausgewählt ist aus der Gruppe, bestehend aus GaN, AlN, AlGaN und Kombinationen derselben.

22. Verfahren nach Anspruch 12, wobei das selektive Aufwachsen der Verbindungshalbleiterdünnschicht zwischen den runden Kugeln umfasst:
Halten eines Reaktors auf einem konstanten Druck und bei einer konstanten Temperatur;
Injizieren reaktiver Precursor mit vorgegebenen Flussraten durch getrennte Leitungen in den Reaktor; und
Aufwachsen einer Verbindungshalbleiterdünnschicht durch Anstoßen einer chemischen Reaktion zwischen den reaktiven Precursorn im Reaktor.

23. Verfahren nach Anspruch 22, wobei die Verbindungshalbleiterdünnschicht aufgewachst wird, während der Reaktor bei einer Temperatur in einem Bereich von 900 bis 1150 °C gehalten wird.

24. Verfahren nach Anspruch 22, wobei die reaktiven Precursor einen ersten reaktiven Precursor, der ausgewählt ist aus der Gruppe, bestehend aus TMA1, TMGa, TEGa und GaCl₃, und einen zweiten reaktiven Precursor, der ausgewählt ist aus der Gruppe, bestehend aus NH₃, N₂ und tertiärem Butylamin (N(C₄H₉)H₂), umfassen, und wobei die Verbindungshalbleiterdünnschicht aus einem Material gebildet ist, das ausgewählt ist aus der Gruppe, bestehend aus GaN, AlN, AlGaN und Kombinationen derselben.

25. Verfahren nach Anspruch 12, wobei die Verbindungshalbleiterdünnschicht ferner wenigstens ein Material aufweist, das ausgewählt ist aus der Gruppe, bestehend aus Si, Ge, Mg, Zn, O, Se, Mn, Ti, Ni und Fe.

26. Verfahren nach Anspruch 12, wobei das Substrat aus einem Material gebildet ist, das ausgewählt ist aus der Gruppe, bestehend aus Al₂O₃, GaAs, Spinell, InP, SiC und Si.

## Revendications

1. Dispositif à semi-conducteur composé comprenant :
un substrat;
une première pluralité de billes sphériques agencées sur le dessus du substrat ; et
un premier film mince à semi-conducteur composé disposé entre et sur les billes sphériques, le film mince à semi-conducteur composé émettant l'une d'une lumière ultraviolette (UV), d'une lumière visible (V) et d'une lumière infrarouge (IR),
dans lequel les billes sphériques sont formées d'une matière sélectionnée à partir du groupe constitué par SiO₂, Al₂O₃, TiO₂, ZrO₂, Y₂O₃, ZrO₂, CuO, Cu₂O, Ta₂O₅, PZT(Pb(Zr,Ti)O₃), Nb₂O₅, FeSO₄, Fe₃O₄, Fe₂O₃, Na₂SO₄, GeO₂, CdS et un métal.

2. Dispositif selon la revendication 1, comprenant en outre :
une couche tampon disposée entre le substrat et le premier film mince à semi-conducteur composé pour minimiser une densité de défauts cristallins du premier film mince à semi-conducteur composé en réduisant la différence de constante de réseau cristallin au premier film mince à semi-conducteur composé.

3. Dispositif selon la revendication 1, comprenant en outre :
une couche tampon disposée entre le substrat et le premier film mince à semi-conducteur composé pour minimiser une densité de défauts cristallins du premier film mince à semi-conducteur composé en réduisant la différence de constante de réseau cristallin au premier film mince à semi-conducteur composé ;
une seconde pluralité de billes sphériques agencées sur le premier film mince à semi-conducteur composé ; et
un second film mince à semi-conducteur composé disposé entre et sur la seconde pluralité de billes sphériques agencées sur le premier film mince à semi-conducteur composé, le second film mince à semi-conducteur composé émettant l'une d'une lumière ultraviolette (UV), d'une lumière visible (V) et d'une lumière infrarouge (IR).

4. Dispositif selon la revendication 1, comprenant en outre :
une couche tampon disposée entre le substrat et le premier film mince à semi-conducteur composé pour minimiser une densité de défauts cristallins du premier film mince à semi-conducteur composé en réduisant la différence de constante de réseau cristallin au premier film mince à semi-conducteur composé,
la première pluralité de billes sphériques étant disposée sur le premier film mince à semi-conducteur composé,
un second film mince à semi-conducteur composé, le second film mince à semi-conducteur composé étant disposé entre et sur les billes sphériques disposées sur le premier film mince à semi-conducteur composé.

5. Dispositif selon la revendication 1, comprenant en outre un second film mince à semi-conducteur composé empilé sur le premier film mince à semi-conducteur composé et le second film mince à semi-conducteur composé est formé à partir d'une matière différente de celle du premier film mince à semi-conducteur composé.

6. Dispositif selon la revendication 2, dans lequel la couche tampon est formée d'une matière sélectionnée à partir du groupe constitué par GaN, AlN, AlGaN et des combinaisons de ceux-ci.

7. Dispositif selon la revendication 6, dans lequel la couche tampon et le premier film mince à semi-conducteur composé ont la même structure cristalline et ont une différence de constante de réseau cristallin de moins de 20 %.

8. Dispositif selon la revendication 1, dans lequel chacune des billes sphériques a un diamètre allant de 10 nm à 2 µm.

9. Dispositif selon la revendication 1, dans lequel le film mince à semi-conducteur composé est formé à partir d'une matière sélectionnée à partir du groupe constitué par GaN, AIN, InN et des combinaisons de ceux-ci (Ga₁₋ₓAl_{1-y}In_{1-z}N, 0 ≤ x, y et z ≤ 1).

10. Dispositif selon la revendication 1, dans lequel le film mince à semi-conducteur composé contient en outre au moins une matière sélectionnée à partir du groupe constitué par Si, Ge, Mg, Zn, O, Se, Mn, Ti, Ni et Fe.

11. Dispositif selon la revendication 1, dans lequel le substrat comprend une matière sélectionnée à partir du groupe constitué par Al₂O₃, GaAs, spinelle, InP, SiC et Si.

12. Procédé de fabrication d'un dispositif à semi-conducteur composé, comprenant :
la formation d'une pluralité de billes sphériques ;
le revêtement des billes sphériques sur un substrat ;
la croissance d'une couche tampon sur le substrat sur lequel les billes sphériques sont revêtues ;
la croissance sélective d'un film mince à semi-conducteur composé entre les billes sphériques ;
la croissance du film mince à semi-conducteur composé dans une direction latérale de sorte qu'il croît sur les billes sphériques ; et
la croissance continue du film mince à semi-conducteur composé à une épaisseur souhaitée.

13. Procédé selon la revendication 12, comprenant en outre :
après la croissance continue du film mince à semi-conducteur composé à l'épaisseur souhaitée,
la formation d'une pluralité de billes sphériques ;
le revêtement des billes sphériques sur le film mince à semi-conducteur composé ;
la croissance sélective d'un autre film mince à semi-conducteur composé sur le film mince à semi-conducteur composé sur lequel les billes sphériques sont revêtues et entre les billes sphériques ; et
la croissance pour le film mince à semi-conducteur composé dans une direction latérale et sur les billes sphériques.

14. Procédé de fabrication d'un dispositif à semi-conducteur composé, comprenant :
la croissance d'une couche tampon sur un substrat ;
la croissance sélective d'un premier film mince à semi-conducteur composé sur la couche tampon ;
la croissance d'agrégats ou d'îlots pour le premier film mince à semi-conducteur composé dans une direction latérale de façon à combiner en premier film mince à semi-conducteur composé ;
la formation d'une pluralité de billes sphériques ;
le revêtement des billes sphériques sur le premier film mince à semi-conducteur composé ;
la croissance sélective d'un second film mince à semi-conducteur composé sur le premier film mince à semi-conducteur composé et entre les billes sphériques ;
la croissance pour le second film mince à semi-conducteur composé dans une direction latérale et sur les billes sphériques ; et
la croissance continue du second film mince à semi-conducteur composé à une épaisseur souhaitée.

15. Procédé selon la revendication 12, dans lequel chacune des billes sphériques a un diamètre dans la plage de 10 nm à 2 µm.

16. Procédé selon la revendication 12, dans lequel les billes sphériques sont formées d'une matière sélectionnée à partir du groupe constitué par SiO₂, Al₂O₃, TiO₂, ZrO₂, Y₂O₃-ZrO₂, CuO, Cu₂O, Ta₂O₅, PZT(Pb(Zr,Ti)O₃), Nb₂O₅, FeSO₄, Fe₃O₄, Fe₂O₃, Na₂SO₄, GeO₂, CdS et un métal.

17. Procédé selon la revendication 12, dans lequel la formation des billes sphériques comprend :
la fabrication d'une première solution en dissolvant du tétraéthylorthosilicate (TEOS) dans de l'éthanol anhydre ;
la fabrication d'une seconde solution en mélangeant une solution d'ammoniac - éthanol avec de l'eau déionisée et de l'éthanol ;
le mélange des première et seconde solutions et l'agitation du mélange des première et
seconde solutions à une température prédéterminée pendant une quantité de temps prédéterminée ;
la séparation des billes sphériques du mélange agité en utilisant un processus de séparation centrifuge ; et
la formation des billes sphériques en répartissant les billes sphériques séparées dans une solution d'éthanol.

18. Procédé selon la revendication 12, dans lequel la couche tampon est formée d'une matière sélectionnée à partir du groupe constitué par GaN, AlN, AIGaN et des combinaisons de ceux-ci avec une épaisseur dans la plage de 10 à 200 nm, pour minimiser une densité de défauts cristallins du film mince à semi-conducteur composé en réduisant la différence de constante de réseau cristallin au film mince à semi-conducteur composé.

19. Procédé selon la revendication 12, dans lequel la croissance de la couche tampon comprend :
le maintien d'un réacteur à une pression et à une température constantes ;
l'injection de précurseurs réactifs à des débits prédéterminés par l'intermédiaire de conduites distinctes dans le réacteur ; et
la croissance d'une couche tampon à une épaisseur souhaitée en provoquant une réaction chimique entre les précurseurs réactifs dans le réacteur.

20. Procédé selon la revendication 19, dans lequel la couche tampon est cultivée tandis que le réacteur est maintenu à une température dans une plage de 400 à 1200 °C.

21. Procédé selon la revendication 19, dans lequel les précurseurs réactifs incluent un premier précurseur réactif, qui est sélectionné à partir du groupe constitué par TMA1, TMGa, TEGa et GaCl₃, et un second précurseur réactif, qui est sélectionné à partir du groupe constitué par NH₃, N₂ et butylamine tertiaire (N(C₄H₉)H₂), et la couche tampon est formée d'un élément sélectionné à partir du groupe constitué par GaN, AlN, AIGaN et des combinaisons de ceux-ci.

22. Procédé selon la revendication 12, dans lequel la croissance sélective du film mince à semi-conducteur composé entre les billes sphériques comprend :
le maintien d'un réacteur à une pression et à une température constantes ;
l'injection de précurseurs réactifs à des débits prédéterminés à travers des conduites distinctes dans un réacteur ; et
la croissance d'un film mince à semi-conducteur composé en provoquant une réaction chimique entre les précurseurs réactifs dans le réacteur.

23. Procédé selon la revendication 22, dans lequel le film mince à semi-conducteur composé est cultivé tandis que le réacteur est maintenu à une température dans une plage de 900 à 1 150 °C.

24. Procédé selon la revendication 22, dans lequel les précurseurs réactifs incluent un premier précurseur réactif, qui est sélectionné à partir du groupe constitué par TMA1, TMGa, TEGa et GaCl₃, et un second précurseur réactif, qui est sélectionné à partir du groupe constitué par NH₃, N₂ et butylamine tertiaire (N(C₄H₉)H₂), et le film mince à semi-conducteur composé est formé d'une matière sélectionnée à partir du groupe constitué par GaN, AIN, AlGaN et des combinaisons de ceux-ci.

25. Procédé selon la revendication 12, dans lequel le film mince à semi-conducteur composé contient en outre au moins une matière sélectionnée à partir du groupe constitué par Si, Ge, Mg, Zn, O, Se, Mn, Ti, Ni et Fe.

26. Procédé selon la revendication 12, dans lequel le substrat est formé d'une matière sélectionnée à partir du groupe constitué par Al₂O₃, GaAs, spinelle, InP, SiC et Si.
